(19) Europäisches Patentamt
European Patent Office
Office européen des brevets

(11) **EP 4 086 703 A1**

(12) **EUROPEAN PATENT APPLICATION**

(43) Date of publication:
**09.11.2022 Bulletin 2022/45**

(21) Application number: **21172589.0**

(22) Date of filing: **06.05.2021**

(51) International Patent Classification (IPC):
***G03F 7/20*** (2006.01)

(52) Cooperative Patent Classification (CPC):
**G03F 7/70616; G03F 7/705**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **BATISTAKIS, Chrysostomos**
**5500 AH Veldhoven (NL)**

• **PISARENCO, Maxim**
**5500 AH Veldhoven (NL)**
• **VAN KRAAIJ, Markus Gerardus Martinus Maria**
**5500 AH Veldhoven (NL)**
• **RUTIGLIANI, Vito Daniele**
**5500 AH Veldhoven (NL)**
• **MIDDLEBROOKS, Scott Anderson**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD FOR DETERMINING A STOCHASTIC METRIC RELATING TO A LITHOGRAPHIC PROCESS**

(57)    Disclosed is a method of determining at least one stochastic metric relating to a lithographic process and associated optical metrology device. The method comprises obtaining a trained machine learning model, the machine learning model having been trained to infer one or more stochastic metric values for said stochastic metric from optical metrology data. Optical metrology data comprising at least one measurement signal relating to a structure having been exposed in a lithographic process is obtained and the trained machine learning model used to infer a value for said stochastic metric from said optical metrology data.

Fig. 4

EP 4 086 703 A1

**Description**

BACKGROUND

Field of the Invention

The present invention relates to methods and apparatus for applying patterns to a substrate in a lithographic process.

Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth or critical dimension (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools.

In performing lithographic processes, such as application of a pattern on a substrate or measurement of such a pattern, process control and/or quality monitoring methods may rely on a stochastic analysis of features formed by the lithographic processes. Such a stochastic analysis presently requires high resolution metrology which may typically be implemented using a scanning electron microscope SEM). However, SEM metrology is slow, and therefore unsuitable for high volume manufacturing.

SUMMARY OF THE INVENTION

It is an object of the invention to provide a method of stochastic metrology at faster speeds than presently possible using an SEM.

In a first aspect of the invention there is provided a method of determining at least one stochastic metric relating to a lithographic process, the method comprising: obtaining a trained machine learning model, the machine learning model having been trained to infer one or more stochastic metric values for said stochastic metric from optical metrology data, said trained machine learning model having been trained on training optical metrology data and training stochastic metric data, wherein the training optical metrology data comprises a plurality of measurement signals, each relating to scattered radiation having been scattered by a training structure of a plurality of training structures on a training substrate; and the training stochastic metric data comprises stochastic metric values relating to said training structures, wherein multiple instances of said training structures have been formed with a variation in one or more process parameters on which said stochastic metric is dependent; obtaining optical metrology data comprising at least one measurement signal relating to a structure having been exposed in a lithographic process; and using the trained machine learning model to infer a value for said stochastic metric from said optical metrology data.

By using a using a trained machine learning model as described, an accurate method to derive stochastic metric is possible based on less time-consuming (compared to SEM metrology) optical metrology data.

In a second aspect of the invention, there is provided a computing apparatus comprising a processor, and being configured to perform the method of the first aspect.

In a third aspect of the invention, there is provided a scanning electron microscopy inspection apparatus being operable to image a plurality of features on a substrate, and comprising the computing apparatus of the second aspect.

In a fourth aspect of the invention, there is provided a computer program comprising program instructions operable to perform the method of the first aspect when run on a suitable apparatus.

In a fifth aspect of the invention, there is provided an optical metrology device comprising: an optical system operable to obtain optical metrology data comprising at least one measurement signal relating to a structure having been exposed in a lithographic process; non-transient data carrier comprising a trained machine learning model, the machine learning model having been trained to infer one or more stochastic metric values for said stochastic metric from optical metrology data, said trained machine learning model having been trained on training optical metrology data and training stochastic metric data, wherein the training optical metrology data comprises a plurality of measurement signals, each relating to scattered radiation having been scattered by a training structure of a plurality of training structures on a training substrate; and the training stochastic metric data comprises stochastic metric values relating to said training structures, wherein multiple instances of said training structures have been formed with a variation in one or more process parameters on which said stochastic metric is dependent; and a processor being operable use the trained machine learning model to infer a value for said stochastic metric from said optical metrology data.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example, with reference to the accompanying drawings in which:

Figure 1 depicts a lithographic apparatus together with other apparatuses forming a production facility for semiconductor devices;
Figure 2 schematically depicts two examples of stochastic variation: (a) line edge roughness LER; and (b) schematically line width roughness (LWR);
Figure 3 (a) is a schematic drawing of an optical metrology apparatus operable to implement methods according to an embodiment; and (b) a target measurable using such a tool;
Figure 4 is a flow diagram describing a method of training and using a machine learning model to infer stochastic related data from optical metrology data according to an embodiment of the invention; and
Figure 5 is a plot of defect rate DR(SEM) as measured using a scanning electron microscope against defect rate DR(IDM) as measured using an optical metrology tool such as illustrated in Figure 3(a) .

DETAILED DESCRIPTION

Before describing embodiments of the invention in detail, it is instructive to present an example environment in which embodiments of the present invention may be implemented.

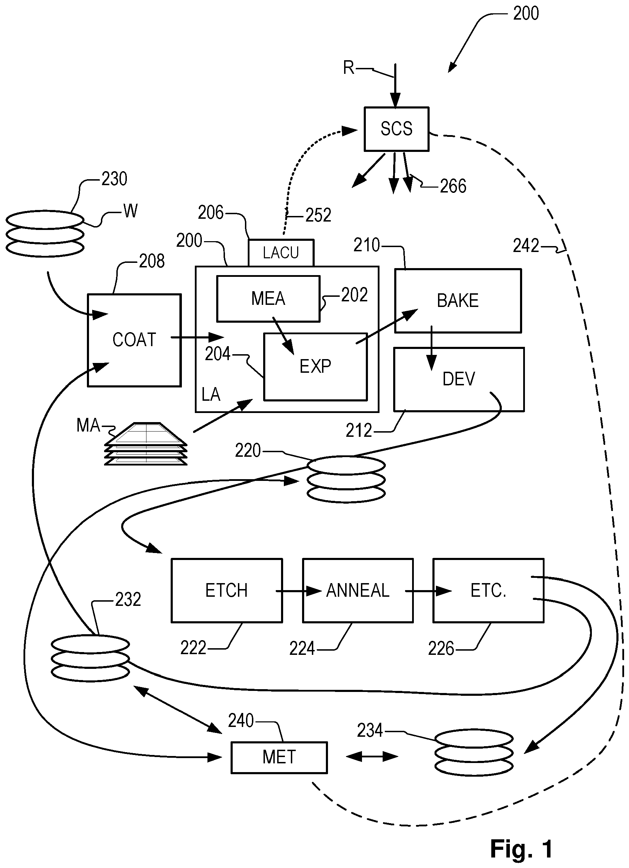

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands.

The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Another example of a metrology station is a scanning electron microscope (SEM), otherwise referred to as an electron beam (e-beam) metrology device, which may be included in addition to, or as an alternative to, a scatterometer. As such, metrology apparatus 240 may comprise an e-beam or SEM metrology device, either alone or in addition to a scatterometer. E-beam and SEM metrology devices have the advantage of measuring features directly (i.e., they directly image the features), rather than the indirect measurement techniques used in scatterometry (where parameter values are determined from reconstruction from and/or asymmetry in diffraction orders of radiation diffracted by the structure being measured). The main disadvantage with e-beam or SEM metrology devices is their measurement speed, which is much slower than scatterometry, limiting their potential application to specific offline monitoring processes.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

Lithographic projection apparatuses typically project a patterned (i.e., by a reticle) image at a point immediately above the substrate, and then ultimately into the resist. The projected image is called the aerial image, which comprises a distribution of light intensity as a function of spatial position in the image plane. The aerial image is the source of the information that is exposed into the resist, forming a gradient in dissolution rates that enables the three-dimensional resist image to appear during development.

Stochastic induced failure predictions are typically made based on one or more stochastic metrics. Such stochastic metrics may include stochastic measurements on the variation of one or more dimensional parameters; e.g. one or more of,: CD (so called Local CD Uniformity, LCDU), line edge position (so called line edge roughness LER), or linewidth (so called linewidth roughness LWR), for example. Accurate measurement of the number of failures is cumbersome, as low failure rates (e.g., of the order of 1 per million to 1 per billion) can be expected in an optimized process.

Imaging, using a lithographic projection apparatus, will result in a stochastic variation in one or more parameters, such as pronounced line width roughness (LWR) and local CD variation in small two-dimensional features such as holes. The stochastic variation may be attributed to factors such as photon shot noise, photon-generated secondary electrons, photon absorption variation, photon-generated acids in the resist. In the case of EUV lithography, the small sizes of features for which EUV is called for further compound this stochastic variation. The stochastic variation in smaller features are a significant factor in production yield and justifies inclusion in a variety of optimization processes of the lithographic projection apparatus.

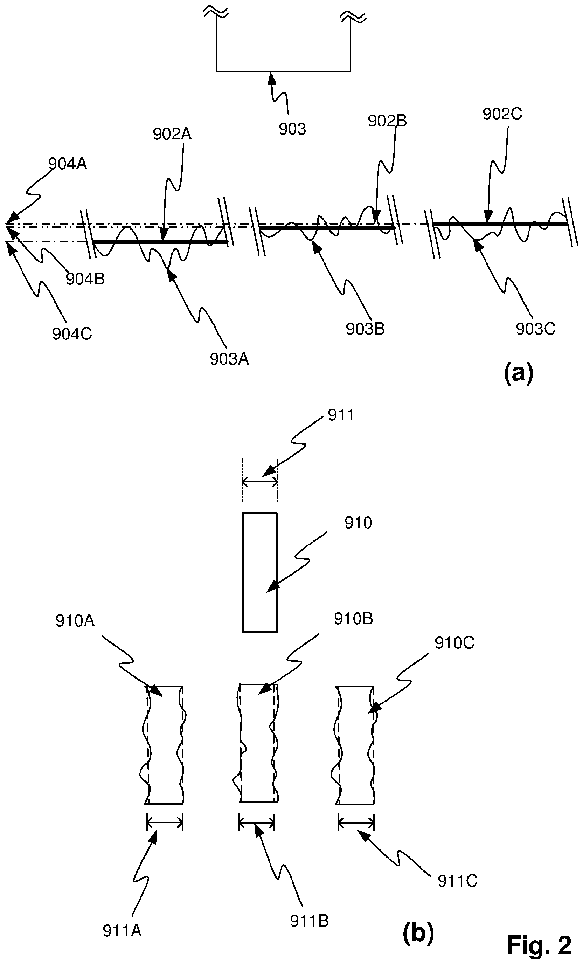

Figure 2(a) schematically depicts a stochastic effect, line edge roughness LER. Assuming all conditions are identical in three exposures or simulations of exposure of an edge 903 of a feature on a design layout, the resist images 903A, 903B and 903C of the edge 903 may have slightly different shapes and locations. Locations 904A, 904B and 904C of the resist images 903 A, 903B and 903C may be measured by averaging the resist images 903A, 903B and 903C, respectively. LER of the edge 903 may be a measure of the spatial distribution of the locations 904A, 904B and 904C. For example, the LER may be a $3\sigma$ of the spatial distribution (assuming the distribution is a normal distribution). The LER may be derived from many exposures or simulation of the edge 903.

Figure 2(b) schematically depicts LWR. Assuming all conditions are identical in three exposures or simulations of exposure of a long rectangle feature 910 with a width 911 on a design layout, the resist images 910A, 910B and 910C of the rectangle feature 910 may have slightly different widths 911A, 911B and 911C, respectively. LWR of the rectangle feature 910 may be a measure of the distribution of the widths 911A, 911B and 911C. For example, the LWR may be a $3\sigma$ of the distribution (assuming the distribution is a normal distribution). The LWR may be derived from many exposures or simulation of the rectangle feature 910. In the context of a short feature (e.g., a contact hole), the widths of its images are not well defined because long edges are not available for averaging their locations. A similar quantity, LCDU, may be used to characterize the stochastic variation. The LCDU is a $3\sigma$ of the distribution (assuming the distribution is a normal distribution) of measured CDs of images of the short feature.

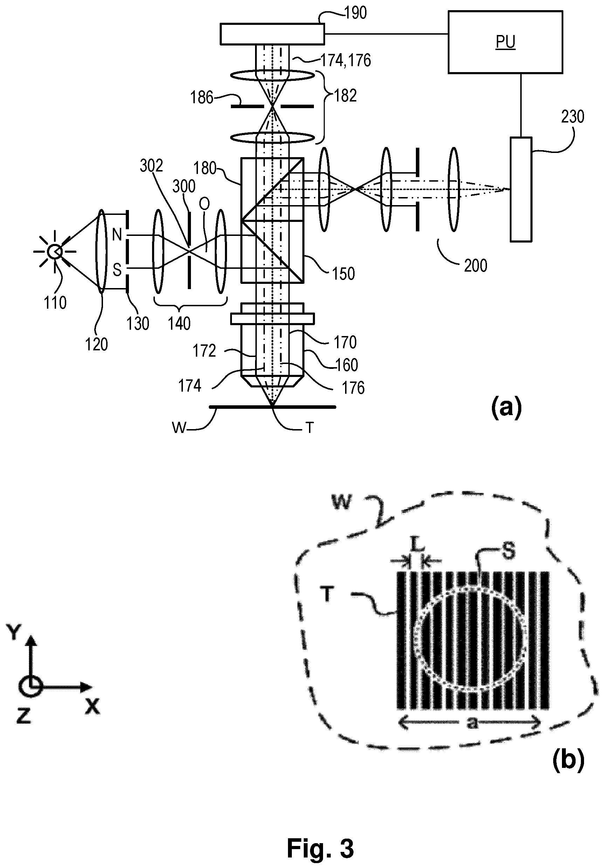

Figure 3(a) illustrates an example of a metrology apparatus 100 suitable for use in embodiments of the invention disclosed herein. The principles of operation of this type of metrology apparatus and in-die metrology (IDM) techniques for which it may be used for are explained in more detail in the U.S. Patent Application Nos. US 2006-033921, US 2010-201963 and WO2017148982, which are incorporated herein in their entireties by reference. An optical axis, which has several branches throughout the apparatus, is represented by a dotted line O. In this apparatus, radiation emitted by source 110 (e.g., a xenon lamp) is directed onto substrate W via by an optical system comprising: lens system 120, aperture plate 130, lens system 140, a partially reflecting surface 150 and objective lens 160. In an embodiment these lens systems 120, 140, 160 are arranged in a double sequence of a 4F arrangement. In an embodiment, the radiation emitted by radiation source 110 is collimated using lens system 120. A different lens arrangement can be used, if desired. The angular range at which the radiation is incident on the substrate can be selected by defining a spatial intensity distribution in a plane that presents the spatial spectrum of the substrate plane. In particular, this can be done by inserting an aperture plate 130 of suitable form between lenses 120 and 140, in a plane which is a back-projected image of the objective lens pupil plane. Different intensity distributions (e.g., annular, dipole, etc.) are possible by using different apertures. The angular distribution of illumination in radial and peripheral directions, as well as properties such as wavelength, polarization and/or coherency of the radiation, can all be adjusted to obtain desired results. For example, one or more interference filters 130 can be provided between source 110 and partially reflecting surface 150 to select a wavelength of interest in the range of, say, 400 -900 nm or even lower, such as 200 - 300 nm. The interference filter may be tunable rather than comprising a set of different filters. A grating could be used instead of an interference filter. In an embodiment, one or more polarizers 170 can be provided between source 110 and partially reflecting surface 150 to select a polarization of interest. The polarizer may be tunable rather than comprising a set of different polarizers.

The target T is placed with substrate W normal to the optical axis O of objective lens 160. Thus, radiation from source 110 is reflected by partially reflecting surface 150 and focused into an illumination spot S (see Figure 3(b)) on target T on substrate W via objective lens 160. In an embodiment, objective lens 160 has a high numerical aperture (NA), desirably at least 0.9 or at least 0.95. An immersion metrology apparatus (using a relatively high refractive index fluid such as water) may even have a numerical aperture over 1.

Rays of illumination 170, 172 focused to the illumination spot from angles off the axis O gives rise to diffracted rays 174, 176. It should be remembered that these rays are just one of many parallel rays covering an area of the substrate including target T. Each element within the illumination spot is within the field of view of the metrology apparatus. Since the aperture in plate 130 has a finite width (necessary to admit a useful quantity of radiation), the incident rays 170, 172 will in fact occupy a range of angles, and the diffracted rays 174, 176 will be spread out somewhat. According to the point spread function of a small target, each diffraction order will be further spread over a range of angles, not a single ideal ray as shown.

At least the zeroth order diffracted by the target on substrate W is collected by objective lens 160 and directed back through partially reflecting surface 150. An optical element 180 provides at least part of the diffracted beams to optical system 182 which forms a diffraction spectrum (pupil plane image) of the target T on sensor 190 (e.g. a CCD or CMOS sensor) using the zeroth and/or first order diffractive beams. In an embodiment, an aperture 186 is provided to filter out certain diffraction orders so that a particular diffraction order is provided to the sensor 190. In an embodiment, the aperture 186 allows substantially or primarily only zeroth order radiation to reach the sensor 190. In an embodiment, the sensor 190 may be a two-dimensional detector so that a two-dimensional angular scatter spectrum of a substrate target T can be measured. The sensor 190 may be, for example, an array of CCD or CMOS sensors, and may use an integration time of, for example, 40 milliseconds per frame. The sensor 190 may be used to measure the intensity of redirected radiation at a single wavelength (or narrow wavelength range), the intensity separately at multiple wavelengths or integrated over a wavelength range. Furthermore, the sensor may be used to separately measure the intensity of radiation with transverse magnetic- and/or transverse electric-polarization and/or the phase difference between transverse magnetic- and transverse electric-polarized radiation.

Optionally, optical element 180 provides at least part of the diffracted beams to measurement branch 200 to form an image of the target on the substrate W on a sensor 230 (e.g. a CCD or CMOS sensor). The measurement branch 200 can be used for various auxiliary functions such as focusing the metrology apparatus (i.e., enabling the substrate W to be in focus with the objective 160), and/or for dark field imaging where the image is formed with zeroth order blocked, such that it is comprised only of a single diffraction order or complementary pair of diffraction orders.

In order to provide a customized field of view for different sizes and shapes of grating, an adjustable field stop 300 is provided within the lens system 140 on the path from source 110 to the objective lens 160. The field stop 300 contains an aperture 302 and is located in a plane conjugate with the plane of the target T, so that the illumination spot becomes an image of the aperture 302. The image may be scaled according to a magnification factor, or the aperture and illumination spot may be in 1:1 size relation. In order to make the illumination adaptable to different types of measurement, the aperture plate 300 may comprise a number of aperture patterns formed around a disc, which rotates to bring a desired pattern into place. Alternatively or in addition, a set of plates 300 could be provided and swapped, to achieve the same effect. Additionally or alternatively, a programmable aperture device such as a deformable mirror array or transmissive spatial light modulator can be used.

Typically, a target will be aligned with its periodic structure features running either parallel to the Y axis or parallel to the X axis. With regard to its diffractive behavior, a periodic structure with features extending in a direction parallel to the Y axis has periodicity in the X direction, while the a periodic structure with features extending in a direction parallel to the X axis has periodicity in the Y direction. In order to measure the performance in both directions, both types of features are generally provided. While for simplicity there will be reference to lines and spaces, the periodic structure need not be formed of lines and space. Moreover, each line and/or space between lines may be a structure formed of smaller sub-structures. Further, the periodic structure may be formed with periodicity in two dimensions at once, for example where the periodic structure comprises posts and/or via holes.

Figure 3(b) illustrates a plan view of a typical target T, and the extent of illumination spot S in the apparatus of Figure 3(a). To obtain a diffraction spectrum that is free of interference from surrounding structures, the target T, in an embodiment, is a periodic structure (e.g., grating) larger than the width (e.g., diameter) of the illumination spot S. The width of spot S may be smaller than the width and length of the target. The target in other words is 'underfilled' by the illumination, and the diffraction signal is essentially free from any signals from product features and the like outside the target itself. This simplifies mathematical reconstruction of the target as it can be regarded as infinite.

The device depicted in Figure 3(a) may be used to determine the value of one or more variables of interest of a target pattern based on measurement data obtained using metrology. Radiation detected by the detector 190 provides a measured radiation distribution (or more generally an angularly resolved parameter distribution) for the target T.

In the metrology apparatus, a substrate support may be provided to hold the substrate W during measurement operations. In an example where the metrology apparatus is integrated with a lithographic apparatus, the two device may have the same substrate table. Coarse and fine positioners may be provided to accurately position the substrate in relation to a measurement optical system. Various sensors and actuators are provided for example to acquire the position of a target of interest, and to bring it into position under the objective lens. Typically many measurements will be made on targets at different locations across the substrate W. The substrate support can be moved in X and Y directions to acquire different targets, and in the Z direction to obtain a desired location of the target relative to the focus of the optical system. It is convenient to think and describe operations as if the objective lens is being brought to different locations relative to the substrate, when, for example, in practice the optical system may remain substantially stationary (typically in the X and Y directions, but perhaps also in the Z direction) and only the substrate moves. Provided the relative position of the substrate and the optical system is correct, it does not matter in principle which one of those is moving in the real world, or if both are moving, or a combination of a part of the optical system is moving (e.g., in the Z and/or tilt direction) with the remainder of the optical system being stationary and the substrate is moving (e.g., in the X and Y directions, but also optionally in the Z and/or tilt direction).

In an embodiment, the measurement accuracy and/or sensitivity of a target may vary with respect to one or more attributes of the beam of radiation provided onto the target, for example, the wavelength of the radiation beam, the polarization of the radiation beam, the intensity distribution (i.e., angular or spatial intensity distribution) of the radiation beam, etc. Thus, a particular measurement strategy can be selected that desirably obtains, e.g., good measurement accuracy and/or sensitivity of the target.

In order to monitor the patterning process (e.g., a device manufacturing process) that includes at least one pattern transfer step (e.g., an optical lithography step), the patterned substrate is inspected and one or more parameters of the patterned substrate are measured / determined. The one or more parameters may include, for example, overlay between successive layers formed in or on the patterned substrate, critical dimension (CD) (e.g., critical linewidth) of, for example, features formed in or on the patterned substrate, focus or focus error of an optical lithography step, dose or dose error of an optical lithography step, optical aberrations of an optical lithography step, placement error (e.g., edge placement error), etc. This measurement may be performed on a target of the product substrate itself and/or on a dedicated metrology target provided on the substrate. The measurement can be performed after-development of a resist but before etching or can be performed after-etch.

In an embodiment, a parameter obtained from a measurement process is a parameter derived from a parameter determined directly from the measurement process. As an example, a derived parameter obtained from a measurement parameter is edge placement error (EPE) for the patterning process. The edge placement error provides a variation in the location of an edge of a structure created by the patterning process. In an embodiment, the edge placement error is derived from an overlay value. In an embodiment, the edge placement error is derived from a combination of an overlay value and at least one stochastic metric. In an embodiment, the edge placement is derived from a combination of an overlay value, at least one CD stochastic metric value (e.g., CDU, LCDU) and (optionally) also another stochastic metric (e.g., edge roughness, shape asymmetry, etc. of the individual structures). In an embodiment, the edge placement error comprises an extreme value (e.g., 3 standard deviation, i.e., 3σ) of overlay and CD errors combined. In an embodiment, the edge placement error has the following form (or comprises at least the first two of the following terms):

$$\sqrt{\left(3\sigma_{overlay}\right)^2 + \left(\frac{3\sigma_{CDUstructures}}{2}\right)^2 + \frac{3\sigma_{OPE.PBA}}{2} + 6\sigma_{LER,LPE}}$$

wherein $\sigma_{overlay}$ corresponds to the standard deviation of overlay, corresponds to the standard deviation of overlay, $\sigma_{CDUstructures}$ corresponds to the standard deviation of the critical dimension uniformity (CDU) of structures created in the patterning process, $\sigma_{OPE.PBA}$ corresponds to the standard deviation of optical proximity effects (OPE) and/or proximity bias average (PBA) which is a difference between CD at pitch to a reference CD, and $\sigma_{LER,LPE}$ corresponds to the standard deviation of line edge roughness (LER) and/or local placement error (LPE). While formulation above is in relation to standard deviation, it can be formulated in a different comparable statistical manner, such as variance.

There are various techniques for making measurements of the structures formed in the patterning process, including the use of a scanning electron microscope, an image-based measurement tool and/or various specialized tools. As discussed above, a fast and non-invasive form of specialized metrology tool is one in which a beam of radiation is directed onto a target on the surface of the substrate and properties of the scattered (diffracted/reflected) beam are measured. By evaluating one or more properties of the radiation scattered by the substrate, one or more properties of the substrate can be determined. This may be termed diffraction-based metrology. One such application of this diffraction-based metrology is in the measurement of feature asymmetry within a target. This can be used as a measure of overlay, for example, but other applications are also known. For example, asymmetry can be measured by comparing opposite parts of the diffraction spectrum (for example, comparing the -1st and +1st orders in the diffraction spectrum of a periodic grating). This can be done as described, for example, in U.S. patent application publication US2006-066855, which is incorporated herein in its entirety by reference. Another application of diffraction-based metrology is in the measurement of feature width (CD) within a target. Such techniques can use the apparatus and methods described above in respect of Figure 3.

A target or structure measured by an apparatus such as depicted in Figure 3(a), and by methods disclosed herein may comprise one or a plurality of geometrically symmetric unit cells or features. As such, the target T or structure can comprise just a single physical instance of a unit cell or feature or can comprise a plurality of physical instances of the unit cells or features.

The target/structure can be a specially designed target. In an embodiment, the target is for a scribe lane. In an embodiment, the target can be an in-die target, i.e., the target is among the device pattern (and thus between the scribe lanes). In an embodiment, the target can have a feature width or pitch comparable to device pattern features. For example, the target feature width or pitches can be less than or equal to 300% of the smallest feature size or pitch of the device pattern, be less than or equal to 200% of the smallest feature size or pitch of the device pattern, be less than or equal to 150% of the smallest feature size or pitch of the device pattern, or be less than or equal to 100% of the smallest feature size or pitch of the device pattern.

The target or structure can be a device structure. For example, the target or structure can be a portion of a memory device (which often has one or more features that are, or can be, geometrically symmetric). Where the device structure is non-periodic or non-regular (e.g., logic structure), the target may be superficially similar to the logic structure, (e.g., of similar feature size and configuration) such that it comprises a regularized extraction of the logic structure, which mimics the exposure performance of the logic structure.

Desirably, for each structure, the physical instance of the unit cell/feature or the plurality of physical instances of the unit cells/features collectively fills a beam spot of the metrology apparatus. In that case, the measured results comprise essentially only information from the physical instance of the unit cell (or its plurality of instances). In an embodiment, the beam spot has a cross-sectional width of 50 microns or less, 40 microns or less, 30 microns or less, 20 microns or less, 15 microns or less, 10 microns or less, 5 microns or less, or 2 microns or less. Structure features may be of the scale of 20nm pitch, and therefore each measurement or capture may comprise between 200 and 300 features (e.g., about 250 features) should the beam spot be 5µm for example. As such, each structure or target may comprise hundreds of features.

The essence of stochastics relates to the absorbed dose, which fluctuates due to the limited number of (absorbed) photons and resist chemical noise. This is practically reflected in CD variations from feature-to-feature and/or over the length of a feature. As such, a stochastic metric in the context of this disclosure may comprise a defect rate or other defect metric, or e.g., an average or mean of: line edge roughness (LER), line width roughness (LWR), LCDU, contact hole LCDU, circle edge roughness (CER) edge placement error (EPE), or a combination thereof.

At present, failure rate may be determined by counting defects obtained from SEM (e.g., e-beam) images. Typically, this failure rate estimation is performed by collecting multiple metrology points, e.g. contact holes (CHs) and counting the number of failures within the sample. While e-beam metrology is accurate, it is time consuming, and therefore is not always practical and non-ideal for massive defect metrology. Because mean CD strongly relates to the pattern defect rate, CD SEM helps in HVM as a yield-indicator. The mean CD, as calculated from e.g., a few hundred of CHs is sufficient to obtain a rough estimation of the failure rate. However, CH arrays with the same mean CD can have different failure rates, due to focus fluctuations.

It is proposed herein to use optical metrology (e.g., scatterometer based metrology) pupil measurements for a fast stochastic defect-rate estimation across wafer. Such metrology may use raw pupil data (e.g., In-Device Metrology (IDM) raw pupil data) as an input for a trained machine learning model (e.g., a neural network model or convolutional neural network (CNN)), the model being trained to infer a defect rate prediction and/or other stochastic metric prediction from the raw pupil data. Each measurement may yield a respective measurement signal. For example, in-device metrology may be based on detection of a measurement signal comprising an angularly resolved distribution (e.g., an angularly resolved intensity and/or diffraction efficiency distribution) in a pupil plane from radiation scattered by a structure on a wafer following illumination of the structure. Diffraction efficiency (a dimensionless value) describes the relative intensities of the diffraction beams, and may comprise a ratio of diffracted versus incident light intensity. Such an angularly resolved distribution measured at the pupil plane will be referred to simply as a "pupil" or "pupil measurement" in the description below. The pupils used may, for example, be the raw pupil or unprocessed pupil (other than, optionally, any normalization).

The angularly resolved distribution may be obtained from only the zeroth order of the radiation scattered by the structure, from only one or more higher orders of the radiation scattered by the structure or a combination of the zeroth order and one or more higher orders of the radiation scattered by the structure. IDM metrology based on analysis of the zeroth order (intensity distribution) to infer overlay/CD at device resolution (given device features are periodic) is described in the aforementioned WO2017148982, for example.

IDM may be performed on targets or structures comprising a feature size similar or the same as product features, and/or directly on the product features provided that they are sufficiently regularized (e.g., periodic). The IDM data may be obtained from pre-etch measurements of structures in resist (i.e., after-develop metrology ADI) and/or post-etch measurement of structures (i.e., after-etch metrology AEI).

Such a method can, for example, facilitate hybrid metrology techniques comprising a combination of optical metrology and SEM metrology, such that (for example) a fast optical wafer scan can be performed, and the results of this optical metrology used to guide the slower but more accurate (or at least higher resolution) SEM inspection towards a few critical locations.

In optical (e.g., IDM) metrology, the pupil resolution is insufficiently high to enable direct detection of individual stochastic variations and defects; e.g., which may occur on the order of a single defective feature for every 10000 or more good features (noting that the measurement spot may comprise over 100 individual features for a single measurement). However, the inventors have determined that such a pupil may be used as an input for a suitably trained model, which is then able to provide a very accurate estimation of one or more stochastic metrics such as the total defect rate or other defect metric and/or LCDU; for example when tested over varied process parameters (e.g., varied dose and focus conditions).

Stochastic defects may result from both photon shot noise and resist chemical noise. Because of this, stochastic variability in resist is both aerial image dependent and resist dependent. The inventors have observed that the stochastic properties of a specific pattern correlate well with the average geometric and material properties of the pattern, this information being present in the IDM raw pupil. For example, defect-rate and LCDU variations for a given pattern and resist vary with process parameter variations such as dose and/or focus variations. The IDM pupils contain information on the averaged 3D profile geometry, which also vary with dose and/or focus variation. As such, by varying one or more process parameters (e.g., a focus-exposure matrix) and/or feature dimensions between training structures or targets on a training substrate, a machine learning model can be trained on the pupils obtained from measurement of these structures. The process parameters (such as focus and/or dose) variations cause changes in geometric properties (sensitivity depends on resist characteristics). These geometric properties (measurable with an SEM/e-beam tool) correlate with the stochastic metric and can also be measured by optical (e.g., IDM) metrology.

It may be appreciated that focus effects on the printed pattern might not be captured by the e-beam tool, but still captured by the optical tool. As such, a variation in dose and/or focus may cause stochastic pattern changes can be captured by the e- beam tool (e.g., failure rate and LCDU); however the inventors have determined that some 3D changes which effect the failure rate may actually be better captured via optical metrology.

The machine learning model may be trained to a known or observed defect rate or other stochastic metric based process window which defines a process space comprising process parameter values which are expected to yield good or non-defective dies (at least in terms of an acceptable probability), and such that process parameter values outside of the process window may be expected to result in dies having an unacceptable probability of defect. For example, the machine learning model may be trained on such a defect rate based process window as measured by an e-beam/SEM tool or any other tool with sufficient resolution to directly measure the stochastic metric/defect rate. In a specific example, the process window may comprise a focus-exposure window, where focus and dose are the process parameters of interest which are varied over the structures measured by the e-beam/SEM tool so as to define the process window. Optical measurements, e.g., pupil measurements, across all or part of the process window or focus-exposure window are obtained from the same wafers as measured by the e-beam/SEM tool. The optical measurements and corresponding SEM based defect rate data/process window may be used together as training input to the machine learning model. For example, each optical measurement/pupil may be labeled with its corresponding defect rate data and process parameter value(s) and used to train the machine learning model. In addition or alternatively to focus and/or dose, the process parameter may relate to a parameter of a reticle used in the exposure, e.g., a reticle feature dimension on which imaged feature dimensions such as CD are dependent. By varying this reticle feature dimension, CD can be deliberately varied across multiple structures on the training wafer therefore providing a local CD stochastic metric (e.g., LCDU) on which the machine learning model may be trained so that it can map IDM pupils to a LCDU prediction. As with the focus/dose examples, this LCD variation may be associated with a process window comprising LCDU values expected to yield with acceptable probability.

In addition to pupil data from wafers corresponding to the SEM data, the training data may also comprise nominal informative pupils from a reference and/or a simulation. Such nominal informative pupils may relate to non-defect structures/wafers (e.g., simulated pupils from perfectly formed structures) and/or structures/wafers with specific examples of a particular defect. In this way, the model can learn how to contrast the pupil data against the nominal informative pupils and better regress their difference to a given failure rate. As such, the training data may comprise a tensor containing the measured pupil data and the nominal informative pupils.

The trained machine learning model can then be used to infer defect failure rate and/or other stochastic metric based on pupil measurement input.

The machine learning model may be a CNN. More specifically, the CNN may comprise an input layer, an output layer and hidden layers therebetween. The hidden layers may comprise, for example, a number of repetitions of convolution layers, activation layers, and batch normalization layers, followed by one or more dropout layers and one or more full connection layers. In an embodiment, the activation layers may impose a logarithmic activation function in order to linearly span the exponential range of defect rates.

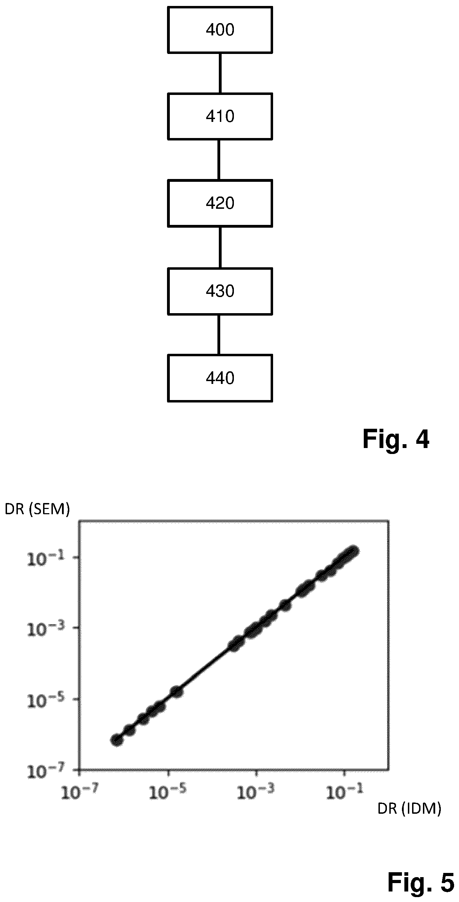

Figure 4 is a flow diagram describing such a method. At step 400, a wafer is exposed using a scanner, with at least one process parameter being varied over the wafer. As such, the exposed wafer may comprise a plurality of training structures, each of which may comprise multiple instances of features. The training structures may all be similar, other than there may have been a variation in one or more process parameters used in their formation. Process parameters in this context may describe a parameter of the lithographic apparatus used to image the structure from a reticle (e.g., focus and/or dose) and/or a reticle parameter such as a reticle feature dimension (on which imaged feature dimensions such as CD are dependent). For example, the structures may be repeated for different values of focus and/or dose; e.g., in a similar manner as a focus-exposure matrix FEM, and/or with different values for CD.

The training structures used to train the model may be similar or essentially the same as the structures which will be measured to obtain optical metrology data on which the trained model will be used to infer a stochastic metric in a production setting or HVM setting. However, this is not necessarily essential, and some differences may be accommodated, with a possible impact on inference accuracy by the trained model.

At step 410, high-resolution metrology data is obtained from measurements of the structures on the wafer exposed at step 400 using a high-resolution metrology tool, e.g., having sufficient resolution to be able to be able to individually image each feature or structure and/or directly determine defect rate. As such, a high-resolution metrology tool may have higher resolution than an optical metrology tool, and may comprise an SEM/e-beam tool. Based on this high-resolution metrology data, stochastic metric data may be determined, describing a process window for the process. A process window may describe a process space or range of process parameter values for which the number of defects/defect rate or other stochastic metric is acceptable, e.g., below a threshold. This is indicative of an acceptable probability of there being no defect provided that the process parameters remain within the process window, while outside of this window the number of defects/defect rate or other stochastic metric may be deemed to be unacceptable (i.e., indicative of an unacceptable probability of there being no defect).

At step 420, the same wafers may be measured using an optical metrology tool, e.g., in a pupil plane to obtain pupil measurements or optical metrology data. As such, the wafer may have been imaged with structures or targets suitable for such optical metrology at step 400. The optical metrology data may comprise an angularly resolved distribution such as an angularly resolved intensity distribution or angularly resolved diffraction efficiency distribution. The intensity or diffraction efficiency may be normalized (more detail is provided below). The optical metrology data may relate to measurements of the same structure with different illumination conditions (e.g., combinations of one or more of illumination wavelengths, illumination polarizations and wafer orientations).

At step 430, a machine learning model such as a deep convolutional neural network is trained on the stochastic metric data and optical metrology data such that it is able to map or regress the optical metrology data (e.g., pupil images) to the stochastic metric data (e.g., a particular failure rate or LCDU value). As has been mentioned, additional metrology data of a similar type as the optical metrology data (e.g., pupil images) may also be included in the training data, the additional metrology data relating to nominal informative pupils, e.g., relating to specific stochastic metric examples (e.g., zero defects or specific defect types/rates). This additional metrology data may comprise simulated and/or measured nominal informative pupils.

As is well known, the training may include a validation step, such that the training data is divided into a train set and validation set. In an embodiment, the validation may be performed on a CDU wafer. A CDU wafer may be exposed at best dose and best focus (e.g., using the values known from the training set) but can also comprise dose and focus variations which the trained model has never seen before. This further trains the model to be able to "interpolate" between the dose and focus conditions used for the training set.

At step 440, the trained model may be used to infer a stochastic metric value from one or more optical measurement pupils (e.g., IDM metrology on targets/regular product structures) relating to a production wafer. This step may comprise inputting a pupil to the trained model which can then infer a stochastic metric value from the input.

It can be shown that, compared to an intensity distribution, a diffraction efficiency distribution may show better prediction performance when the machine learning model has been validated on validation data comprising an individual defect rate value per target. An intensity distribution embodiment demonstrates a more acceptable performance when the validation data is averaged over multiple targets; e.g., the validation data comprises defect rates for multiple pupils (for multiple targets) which are averaged (e.g., an average of the log of the defect rates).

Figure 5 is a plot of defect rate as obtained via high resolution (e.g., SEM) metrology DR(SEM) in a conventional manner against defect rate as obtained via optical (e.g., IDM) metrology DR(IDM) using a trained model according to the teachings of this disclosure. It can be seen that there is a near perfect correlation between the values obtained by both methods, such that the model inference from optical metrology performs essentially just as well as conventional SEM metrology for measuring defect rate. Testing has shown a very similar relationship between SEM measurement based mean LCDU and mean LCDU values obtained from optical metrology using a trained model and the teachings herein. It is expected that similar correlations will be found for other stochastic metrics.

As stated, the training may be based on intensity optical metrology data or diffraction efficiency optical metrology data. There are some advantages in using diffraction efficiencies which include less dependence on the size of the training data set (i.e., better performance for smaller training sets, e.g., relating to fewer than 50, 40 or 35 targets per field) and better performance when using the trained model validated on single target measurements rather than averaged measurements over a number of targets. By contrast, an intensity based embodiment shows reliable inference when validated on averaged metrology data (e.g., more than 10 or more than 20 targets or more than 50 targets).

While the training of the model may ideally be performed over all process parameter values likely to be encountered in production, the inventors have determined that the trained model can predict, with good accuracy, a stochastic metric from a pupil relating to a process parameter value which were not used in training and therefore which the model has never encountered before. As such, the model is able to "interpolate" between (and possibly extrapolate beyond) the dose and focus conditions used for the training set.

Step 420 may comprise an optional normalization of the measured pupil intensities or diffraction efficiencies. The normalized intensity $Intensity\_norm_{p,i,j,k}$ may be determined in a high-resolution step by high-resolution determining an intermediate normalized intensity $Intensity\_norm'_{p,i,j,k}$:

$$Intensity\_norm'_{p,i,j,k} = \frac{Intensity_{p,i,j,k}}{max_{p,i,j}\left(Intensity_{p,i,j,k}\right)}$$

where i is the field index for the training data = 1.. $N_{fields\_train}$, j is the target index for the training data = 1.. $N_{targets\_train}$, k is the channel index for the training data = 1.. $N_{channels}$ (where a channel may relate to a particular illumination condition) and p is the pixel index for the training data = 1.. $N_{pixels}$ (where each pupil may comprise multiple pixels, each with a corresponding intensity (or diffraction efficiency) value $Intensity_{p,i,j,k}$ . $max_{p,i,j}\left(Intensity_{p,i,j,k}\right)$ describes the maximum intensity value over the dataset. The diffraction efficiency normalization may be performed in the same way)

An optional second step may comprise determining the normalized intensity $Intensity\_norm_{p,i,j,k}$ as:

$$Intensity\_norm_{p,i,j,k} = Intensity\_norm'_{p,i,j,k} - \sum_{i=1}^{N_{fields\_train}} \sum_{j=1}^{N_{targets\_train}} \frac{Intensity\_norm'_{p,i,j,k}}{N_{fields} * N_{targets}}$$

for $K = 1.. N_{channels}$ For $p = 1.. N_{pixels}$ . The diffraction efficiency normalization may be performed in the same way for diffraction efficiencies. Alternatively, the intermediate normalized intensity $Intensity\_norm'_{p,i,j,k}$ may be used

The proposed method may combine predictions over a few independent targets/structures (e.g., where independent relates to a particular field of view) in order to obtain uncertainty estimates as well as more accurate predictions.

The method can be applied to perform EPE metrology using an optical metrology tool/scatterometer. EPE (described above) is a composed metric, comprising both stochastics and systematics. In an embodiment, EPE may be determined from a determination of LCDU using a trained model and method as disclosed herein and combining this with a conventional overlay measurement (e.g., diffraction based overlay or micro-diffraction based overlay method using an optical metrology tool.

It should be appreciated that any defect-rate prediction provided by the trained machine learning model is not binary (i.e., defect/no defect), but instead can provide a prediction of an expected defect rate for a particular pattern or multiple inspected patterns. For example, the machine learning model may be separately trained for each separate pattern/structure to obtain a dedicated model for that pattern/structure type. Such a model may be trained, for example, on critical patterns with a small process window. In another embodiment, it may be that a single model is trained to maps pupils for multiple different features/targets to a single defect rate prediction or single "global" defect rate .In such an embodiment, it may be that training only on one pattern may be enough in order to teach it to infer such a global defect rate.

Further embodiments of the invention are disclosed in the list of numbered clauses below:

1. A method of determining at least one stochastic metric relating to a lithographic process, the method comprising: obtaining a trained machine learning model, the machine learning model having been trained to infer one or more stochastic metric values for said stochastic metric from optical metrology data, said trained machine learning model having been trained on training optical metrology data and training stochastic metric data, wherein the training optical metrology data comprises a plurality of measurement signals, each relating to scattered radiation having been scattered by a training structure of a plurality of training structures on a training substrate; and the training stochastic metric data comprises stochastic metric values relating to said training structures, wherein multiple instances of said training structures have been formed with a variation in one or more process parameters on which said stochastic metric is dependent; obtaining optical metrology data comprising at least one measurement signal relating to a structure having been exposed in a lithographic process; and using the trained machine learning model to infer a value for said stochastic metric from said optical metrology data.

2. A method according to clause 1, wherein each of said measurement signals comprises an angularly resolved parameter distribution.

3. A method according to clause 2, wherein each angularly resolved parameter distribution comprises an angularly resolved intensity distribution or an angularly resolved diffraction efficiency distribution.

4. A method according to clause 2 or 3, wherein each angularly resolved parameter distribution comprises an angularly resolved parameter distribution obtained from a zeroth order of said scattered radiation.

5. A method according to clause 2, 3 or 4, wherein each angularly resolved parameter distribution comprises an angularly resolved parameter distribution obtained from one or more higher orders of said scattered radiation, a higher order comprising a diffraction order other than the zeroth order.

6. A method according to any of clauses 2 to 5, comprising the step of normalizing said angularly resolved parameter distribution.

7. A method according to any preceding clause, wherein the machine learning model comprises a convolutional neural network.

8. A method according to clause 7, wherein said convolutional neural network comprises one or more activation layers which imposes a logarithmic activation function.

9. A method according to any preceding clause, wherein said training stochastic metric data describes an acceptable space or range of stochastic metric values or related dimensional metric values, and a corresponding acceptable space or range of process parameter values for said one or more process parameters.

10. A method according to any preceding clause, comprising the initial steps of:

obtaining said training optical metrology data and stochastic metric data; and
training said trained machine learning model on said training optical metrology data and stochastic metric data.

11. A method according to clause 10, comprising obtaining high-resolution metrology data; and determining said stochastic metric data from said high-resolution metrology data.

12. A method according to clause 11, wherein said high-resolution metrology data is obtained from scanning electron microscope metrology.

13. A method according to any preceding clause, wherein the training optical metrology data further comprises nominal informative metrology data relating to one or both of:

non-defect measurements and/or simulations; and
specific defect measurements or simulations.

14. A method according to any preceding clause, comprising using the inferred value for the stochastic metric to decide where and/or when to perform further high-resolution metrology.

15. A method according to any preceding clause, wherein said one or more process parameters comprise one or both of focus and dose when forming said training structures.

16. A method according to any preceding clause, wherein said one or more process parameters comprises one or more feature dimensions on a patterning device used to expose said training structures.

17. A method according to any preceding clause, wherein the stochastic metric comprises one or more of: defect rate or other defect metric, line edge roughness, line width roughness, local critical dimension uniformity, circle edge roughness or edge placement error.

18. A processing apparatus comprising a processor, and being configured to perform the method of any preceding clause.

19. An optical inspection apparatus being operable to measure and obtain said optical metrology data, and comprising the computing apparatus of clause 18.

20. A computer program comprising program instructions operable to perform the method of any of clauses 1 to 17, when run on a suitable apparatus.

21. A non-transient computer program carrier comprising the computer program of clause 20.

22. An optical metrology device comprising:
an optical system operable to obtain optical metrology data comprising at least one measurement signal relating to a structure having been exposed in a lithographic process; non-transient data carrier comprising a trained machine learning model, the machine learning model having been trained to infer one or more stochastic metric values for said stochastic metric from optical metrology data, said trained machine learning model having been trained on training optical metrology data and training stochastic metric data, wherein the training optical metrology data comprises a plurality of measurement signals, each relating to scattered radiation having been scattered by a training structure of a plurality of training structures on a training substrate; and the training stochastic metric data comprises stochastic metric values relating to said training structures, wherein multiple instances of said training structures have been formed with a variation in one or more process parameters on which said stochastic metric is dependent; and a processor being operable use the trained machine learning model to infer a value for said stochastic metric from said optical metrology data.

23. An optical metrology device according to clause 22, wherein each of said measurement signals comprises an angularly resolved parameter distribution.

24. An optical metrology device according to clause 23, wherein each angularly resolved parameter distribution comprises an angularly resolved intensity distribution or an angularly resolved diffraction efficiency distribution.

25. A method according to clause 23 or 24, wherein each angularly resolved parameter distribution comprises an angularly resolved parameter distribution obtained from a zeroth order of said scattered radiation.

26. A method according to any of clauses 23 to 25, wherein each angularly resolved parameter distribution comprises an angularly resolved parameter distribution obtained from one or more higher orders of said scattered radiation, a higher order comprising a diffraction order other than the zeroth order.

27. An optical metrology device according to any of clauses 22 to 26, wherein the machine learning model comprises a convolutional neural network.

28. An optical metrology device according to clause 27, wherein said convolutional neural network comprises one or more activation layers being operable to impose a logarithmic activation function.

29. An optical metrology device according to any of clauses 22 to 28, wherein said training stochastic metric data describes an acceptable space or range of stochastic metric values or related dimensional metric values, and a corresponding acceptable space or range of process parameter values for said one or more process parameters.

30. An optical metrology device according to any of clauses 22 to 29, wherein said one or more process parameters comprise one or both of focus and dose when forming said training structures.

31. An optical metrology device according to any of clauses 22 to 30, wherein the stochastic metric comprises or more of defect rate or other defect metric, line edge roughness, line width roughness, local critical dimension uniformity, circle edge roughness or edge placement error.

32. A method of determining a stochastic metric relating to a structure, the method comprising:
obtaining a trained machine learning model, the machine learning model having been trained to correlate training optical metrology data to training stochastic metric data, wherein the training optical metrology data comprises a plurality of measurement signals relating to radiation scattered from a plurality of training structures on a substrate and the training stochastic metric data comprises stochastic metric values relating to said plurality of training structures, wherein the plurality of training structures have been formed with a variation in one or more dimensions on which said stochastic metric is dependent; obtaining optical metrology data from a structure; and using the trained machine learning model to infer a value for said stochastic metric associated with the structure from said optical metrology data.

33. The method of clause 32, wherein the stochastic metric represents a defect probability or a CD variation at a small spatial scale, for example smaller than 1000 times the CD.

34. The method of clause 32 or 33, wherein the measurement signal is a zero order pupil intensity distribution of radiation after being scattered by the structure or training structure.

35. The method of any of clauses 32 to 34, wherein the training stochastic metric data is obtained using an e-beam metrology tool.

36. The method of any of clauses 32 to 35, wherein the variation in the one or more dimensions is associated with a variation in a process parameter of a lithographic apparatus, such exposure dose and/or focus setting.

37. A computer program comprising program instructions operable to perform the method of any of clauses 32 to 36, when run on a suitable apparatus.

38. A non-transient computer program carrier comprising the computer program of clause 37.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1.   A method of determining a stochastic metric relating to a structure on a substrate, the method comprising:

obtaining a trained machine learning model, the machine learning model having been trained to infer one or more stochastic metric values for said stochastic metric from optical metrology data, said trained machine learning model having been trained on training optical metrology data and training stochastic metric data, wherein the training optical metrology data comprises a plurality of measurement signals, each relating to scattered radiation having been scattered by a training structure of a plurality of training structures on a training substrate; and the training stochastic metric data comprises stochastic metric values relating to said training structures, wherein multiple instances of said training structures have been formed with a variation in one or more dimensions on which said stochastic metric is dependent;
obtaining optical metrology data comprising at least one measurement signal relating to the structure; and
using the trained machine learning model to infer a value for said stochastic metric relating to the structure from said optical metrology data.

2.   A method as claimed in claim 1, wherein each of said measurement signals comprises an angularly resolved parameter distribution.

3. A method as claimed in claim 2, wherein each angularly resolved parameter distribution comprises an angularly resolved intensity distribution or an angularly resolved diffraction efficiency distribution.

4. A method as claimed in claim 2 or 3, wherein each angularly resolved parameter distribution comprises an angularly resolved parameter distribution obtained from a zeroth order of said scattered radiation.

5. A method as claimed in any preceding claim, wherein the machine learning model comprises a convolutional neural network.

6. A method as claimed in any preceding claim, wherein the variation in one or more dimensions is associated with a variation in one or more process parameters of a lithographic process used in applying the training structures to the training substrate.

7. A method as claimed in claim 6, wherein said training stochastic metric data describes an acceptable space or range of stochastic metric values or related dimensional metric values, and a corresponding acceptable space or range of values of the one or more process parameters.

8. A method as claimed in claim 6 or 7, wherein the one or more process parameters are one or more of: dose, focus.

9. A method as claimed in any preceding claim, comprising the initial steps of:

   obtaining said training optical metrology data and stochastic metric data; and
   training said trained machine learning model on said training optical metrology data and stochastic metric data.

10. A method as claimed in claim 9, comprising obtaining high-resolution metrology data; and determining said stochastic metric data from said high-resolution metrology data.

11. A method as claimed in claim 10, wherein said high-resolution metrology data is obtained from scanning electron microscope metrology.

12. A method as claimed in any preceding claim, comprising using the inferred value for the stochastic metric to decide where and/or when to perform further high-resolution metrology.

13. A method as claimed in any preceding claim, wherein the stochastic metric comprises one or more of: defect rate or other defect metric, line edge roughness, line width roughness, local critical dimension uniformity, circle edge roughness or edge placement error.

14. A computer program comprising program instructions operable to perform the method of any of claims 1 to 13, when run on a suitable apparatus.

15. A non-transient computer program carrier comprising the computer program of claim 14.

Fig. 1

**(a)**

**(b)**

**Fig. 2**

**(a)**

**(b)**

**Fig. 3**

**Fig. 4**

DR (SEM)

DR (IDM)

**Fig. 5**

Europäisches
Patentamt

European
Patent Office

Office européen
des brevets

# EUROPEAN SEARCH REPORT

Application Number

EP 21 17 2589

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/003609 A1 (SHCHEGROV ANDREI V [US] ET AL) 7 January 2016 (2016-01-07) * paragraphs [0015] - [0023], [0036], [0067] - [0073], [0085], [0096] - [0101], [0113]; claim 15; figure 4 * | 1-4,6-15 | INV. G03F7/20 |
| X | US 2021/035833 A1 (FENG YE [US] ET AL) 4 February 2021 (2021-02-04) * paragraphs [0054] - [0057], [0067], [0068], [0075], [0076], [0079], [0084], [0086]; figure 4 * | 1-5,10, 11,14,15 | |
| A | "Computational EPE-driven SPC for semiconductor manufacturing processes", RESEARCH DISCLOSURE, KENNETH MASON PUBLICATIONS, HAMPSHIRE, UK, GB, vol. 665, no. 40, 1 September 2019 (2019-09-01), page 939, XP007147735, ISSN: 0374-4353 [retrieved on 2019-08-19] * the whole document * | 1-15 | |

TECHNICAL FIELDS
SEARCHED (IPC)

G03F

The present search report has been drawn up for all claims

| Place of search | Date of completion of the search | Examiner |
|---|---|---|
| Munich | 22 October 2021 | Eisner, Klaus |

EPO FORM 1503 03.82 (P04C01)

## ANNEX TO THE EUROPEAN SEARCH REPORT
## ON EUROPEAN PATENT APPLICATION NO.

EP 21 17 2589

This annex lists the patent family members relating to the patent documents cited in the above-mentioned European search report.
The members are as contained in the European Patent Office EDP file on
The European Patent Office is in no way liable for these particulars which are merely given for the purpose of information.

22-10-2021

| Patent document cited in search report | | Publication date | Patent family member(s) | | Publication date |
|---|---|---|---|---|---|
| US 2016003609 | A1 | 07-01-2016 | CN | 106663646 A | 10-05-2017 |
| | | | IL | 249256 A | 31-05-2020 |
| | | | KR | 20170030552 A | 17-03-2017 |
| | | | TW | 201606294 A | 16-02-2016 |
| | | | US | 2016003609 A1 | 07-01-2016 |
| | | | WO | 2016007413 A1 | 14-01-2016 |
| US 2021035833 | A1 | 04-02-2021 | CN | 111971551 A | 20-11-2020 |
| | | | KR | 20200130870 A | 20-11-2020 |
| | | | US | 2021035833 A1 | 04-02-2021 |
| | | | WO | 2019200015 A1 | 17-10-2019 |

EPO FORM P0459

For more details about this annex : see Official Journal of the European Patent Office, No. 12/82

**REFERENCES CITED IN THE DESCRIPTION**

**Patent documents cited in the description**

- US 2006033921 A
- US 2010201963 A
- WO 2017148982 A
- US 2006066855 A